# EUROPÄISCHE PATENTSCHRIFT

(11) **EP 1 507 886 B1**
(45) Veröffentlichungstag und Bekanntmachung des Hinweises auf die Patenterteilung: **30.09.2015**
(21) Anmeldenummer: 03727229.1
(22) Anmeldetag: 09.05.2003
(51) Int. Cl.: C23C 16/04, C23C 16/50, B05D 7/24, C03C 17/00

(54) **VERFAHREN UND VORRICHTUNG ZUR PLASMABEHANDLUNG VON WERKSTÜCKEN**
METHOD AND DEVICE FOR PLASMA TREATING WORKPIECES
PROCEDE ET DISPOSITIF POUR LE TRAITEMENT AU PLASMA DE PIECES

(30) Priorität: 24.05.2002 DE 10223288; 01.06.2002 DE 10224395
(43) Veröffentlichungstag der Anmeldung: 23.02.2005
(73) Patentinhaber: KHS Corpoplast GmbH, 22145 Hamburg (DE)
(72) Erfinder: LITZENBERG, Michael, 21502 Geesthacht (DE); LEWIN, Frank, 22889 Tangstedt (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55239 Gau-Odernheim (DE); LÜTTRINGHAUS-HENKEL, Andreas, 64289 Darmstadt (DE); BICKER, Matthias, 55126 Mainz (DE); KLEIN, Jürgen, 55127 Mainz (DE)
(74) Vertreter: Hausfeld, Norbert
(86) Internationale Anmeldenummer: PCT/DE2003/001501
(87) Internationale Veröffentlichungsnummer: WO 2003/100115

(56) Entgegenhaltungen:
- WO-A-00/58631
- WO-A-95/22413
- WO-A-99/17334
- US-A- 5 084 125
- US-A- 5 762 748

## Beschreibung

Die Erfindung betrifft ein Verfahren zur Plasmabehandlung von Werkstücken, bei dem das Werkstück in eine zumindest teilweise evakuierbare Plasmakammer einer Behandlungsstation eingesetzt wird und bei dem zur Unterstützung einer Handhabung der Werkstücke mindestens ein Teil der Behandlungsstation relativ zu mindestens einem weiteren Teil bewegt wird.

Die Erfindung betrifft darüber hinaus eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer äußeren seitlichen Kammerwandung begrenzt ist.

Derartige Verfahren und Vorrichtungen werden beispielsweise eingesetzt, um Kunststoffe mit Oberflächenbeschichtungen zu versehen. Insbesondere sind auch bereits derartige Verfahren und Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

Bei der überwiegenden Anzahl der bekannten Verfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOₓ verwendet. Derartige Barriereschichten verhindern ein Eindringen von Sauerstoff in die verpackten Flüssigkeiten sowie ein Austreten von Kohlendioxid bei CO₂-haltigen Flüssigkeiten.

Aus der U.S. 5,084,125 A ist es bekannt, innerhalb eines metallischen Gehäuses einer Plasmakammer eine verschiebliche Hülse aus Quarzglas zu verwenden. Die Vorrichtung dient zur Beschichtung von Halbleitersubstraten.

Die bislang bekannten Verfahren und Vorrichtungen sind noch nicht in ausreichender Weise dafür geeignet, für eine Massenproduktion eingesetzt zu werden, bei der sowohl ein geringer Beschichtungspreis je Werkstück als auch eine hohe Produktionsgeschwindigkeit erreicht werden muß.

Aufgabe der vorliegenden Erfindung ist es daher, ein Verfahren der einleitend genannten Art derart anzugeben, daß eine Handhabung der zu behandelnden Werkstücke mit hoher Geschwindigkeit und großer Zuverlässigkeit unterstützt wird.

Diese Aufgabe wird erfindungsgemäß dadurch gelöst, daß eine hülsenförmige äußere Kammerwandung relativ zu einem Kammerboden sowie relativ zu einem Kammerdeckel beweglich ist und positioniert wird, daß ein Werkstück aus einem thermoplastischen Kunststoff behandelt wird und daß als Werkstück eine Getränkeflasche behandelt wird, daß die Positionierung in einer vertikalen Richtung durchgeführt wird und daß der Kammerboden und der Kammerdeckel relativ zu einem Stationsrahmen der Plasmastation in einer statischen Positionierung belassen werden und daß die Kammerwandung relativ zum Kammerdeckel abgedichtet wird.

Weitere Aufgabe der vorliegenden Erfindung ist es, eine Vorrichtung der einleitend genannten Art derart zu konstruieren, daß eine einfache Bewegungskinematik der zu behandelnden Werkstücke unterstützt wird.

Diese Aufgabe wird erfindungsgemäß dadurch gelöst, daß die Kammerwandung hülsenförmig ausgebildet und sowohl relativ zum Kammerboden als auch relativ zum Kammerdeckel beweglich angeordnet ist und daß die Plasmastation zur Beschichtung eines Werkstückes in Form einer Getränkeflasche aus einem thermoplastischen Material ausgebildet ist, daß die Kammerwandung in einer vertikalen Richtung durch eine Verschiebung der Kammerwandung positionierbar ist und daß der Kammerboden und der Kammerdeckel relativ zu einem Stationsrahmen der Plasmastation in einer statischen Positionierung angeordnet sind und daß die Kammerwandung relativ zum Kammerdeckel abgedichtet ist.

Durch die relativ zum Kammerboden und zum Kammerdeckel positionierbare Anordnung der hülsenförmigen Kammerwandung ist es möglich, die zu behandelnden Werkstücke auf einem im wesentlichen gleichbleibenden Höhenniveau zu transportieren. Es wird hierdurch die Zeit für eine gemäß dem Stand der Technik durchzuführende Höhenpositionierung der Werkstücke sowie der hierfür erforderliche konstruktive Aufwand eingespart. Der Kammerboden sowie der Kammerdeckel bleiben auf einem gleichen Höhenniveau angeordnet, so daß mit konstruktiv einfachen Mitteln im Bereich des Kammerdeckels ein Mikrowellengenerator zur Zündung des Plasmas und.im Bereich des Kammerbodens Zuführeinrichtungen für das Vakuum sowie das Prozeßgas angeordnet werden können. Alle Betriebsmittelzuführungen sowie Energieversorgungen können somit über feste Leitungen erfolgen und es werden Kupplungen oder im Hinblick auf ihre Lebensdauer kritische flexible Leitungen vermieden.

Der verfahrenstechnische Ablauf bei der Handhabung der Werkstücke erfolgt derart, daß die verschiebliche Hülse zunächst derart verschoben wird, daß ein Einsetzen des zu beschichtenden Werkstückes in die Kammer ermöglicht wird. Nach einem Einsetzen des Werkstückes wird die hülsenförmige Kammerwandung in die Arbeitspositionierung verschoben und nach einer ausreichenden Evakuierung sowie Zuführung des Prozeßgases kann nach einer Mikrowellenzündung die Plasmabeschichtung oder eine andere Plasmabehandlung durchgeführt werden. Nach einem Abschluß der Behandlung wird die hülsenförmige Kammerwandung erneut verschoben und das behandelte Werkstück kann entnommen sowie ein neues zu behandelndes Werkstück eingesetzt werden.

Eine günstige Schwerkrafteinleitung wird dadurch unterstützt, daß die Positionierung in einer vertikalen Richtung durchgeführt wird.

Eine Betriebsmittelzuführung sowie eine Energieversorgung bei einfacher konstruktiver Gestaltung wird dadurch unterstützt, daß der Kammerboden und der Kammerdeckel relativ zu einem Stationsrahmen der Plasmastation in einer statischen Positionierung belassen werden.

Bei einer Beschichtung von hohlen Werkstücken, die mit ihrer Mündung nach unten angeordnet sind, erweist es sich als vorteilhaft, daß eine Evakuierung einer Kavität der Plasmastation durch den Kammerboden hindurch erfolgt.

Eine gerätetechnisch einfache Realisierung wird ebenfalls dadurch unterstützt, daß durch den Kammerboden hindurch Prozeßgas zugeführt wird.

Eine schnelle und gleichmäßige Verteilung des Prozeßgases in einem Innenraum des Werkstückes kann dadurch erreicht werden, daß das Prozeßgas durch eine Lanze hindurch in einen Innenraum des Werkstückes zugeführt wird.

Zur Vermeidung eines Eindringens eines Umgebungsdruckes in die evakuierte Plasmakammer wird vorgeschlagen, daß die Kammerwandung relativ zum Kammerboden abgedichtet wird.

Eine verschleißarme Durchführung einer Vielzahl von Öffnungs- und Schließvorgängen der Plasmakammer wird dadurch unterstützt, daß die Abdichtung von einer mit der Kammerwandung verbundenen Dichtung durchgeführt wird. Alternativ kann die Dichtung aber auch im Bereich des Kammerbodens angeordnet sein.

Ebenfalls wird zur Gewährleistung einer ausreichenden Abdichtung der Plasmakammer vorgeschlagen, daß die Kammerwandung relativ zum Kammerdeckel abgedichtet wird.

Auch bei der oberen Abdichtung der Plasmakammer kann eine hohe Abdichtungsqualität sowie ein geringer Verschleiß dadurch erreicht werden, daß die Abdichtung von einer im Bereich des Kammerdeckels angeordneten Dichtung durchgeführt wird.

Eine nochmals verbesserte Abdichtungsqualität kann dadurch erreicht werden, daß die Abdichtung zwischen einem Innenflansch der Kammerwandung und einem Flansch des Kammerdekkels durchgeführt wird.

Zur Unterstützung einer steuerbaren Zündung des Plasmas wird vorgeschlagen, daß im Bereich des Kammerdeckels von einem Mikrowellengenerator erzeugte Mikrowellen in die Kavität eingeleitet werden.

Eine Anpassung der Mikrowellenzuführung an konkret vorliegende Einsatzbedingungen wird dadurch erleichtert, daß der Mikrowellengenerator von einem Kopplungskanal mit dem Innenraum der Kavität verbunden wird.

Eine typische Anwendung besteht darin, daß ein Werkstück aus einem thermoplastischen Kunststoff behandelt wird.

Insbesondere ist daran gedacht daß ein Innenraum des Werkstückes behandelt wird.

Ein umfangreiches Anwendungsgebiet wird dadurch erschlossen, daß als Werkstück ein Behälter behandelt wird.

Insbesondere ist dabei daran gedacht, daß als Werkstück eine Getränkeflasche behandelt wird.

Eine hohe Produktionsrate bei großer Zuverlässigkeit und hoher Produktqualität kann dadurch erreicht werden, daß die Plasmastation von einem rotierenden Plasmarad von einer Eingabepositionierung in eine Ausgabepositionierung überführt wird.

Eine Vergrößerung der Produktionskapazität bei nur geringfügig gesteigertem gerätetechnischen Aufwand kann dadurch erreicht werden, daß von einer Plasmastation mehrere Kavitäten bereitgestellt werden.

Bei einer gleichzeitigen Beschichtung von mehreren Werkstücken ist insbesondere daran gedacht, daß eine zur Bereitstellung von mindestens zwei Kavitäten vorgesehene Kammerwandung positioniert wird.

Eine typische Anwendung wird dadurch definiert, daß als Plasmabehandlung eine Plasmabeschichtung durchgeführt wird.

Insbesondere ist daran gedacht, daß die Plasmabehandlung unter Verwendung eines Niederdruckplasmas durchgeführt wird.

Bei einer Beschichtung von Werkstücken aus Kunststoff erweist es sich als vorteilhaft, daß eine Plasmapolymerisation durchgeführt wird.

Eine gute Oberflächenhaftung wird dadurch unterstützt, daß durch das Plasma mindestens zum Teil organische Substanzen abgeschieden werden.

Besonders vorteilhafte Verwendungseigenschaften bei Werkstücken zur Verpackung von Lebensmitteln können dadurch erreicht werden, daß durch das Plasma mindestens zum Teil anorganische Substanzen abgeschieden werden.

Bei der Behandlung von Verpackungen ist insbesondere daran gedacht, daß durch das Plasma eine Substanz zur Verbesserung von Barriereeigenschaften des Werkstückes abgeschieden wird.

Zur Unterstützung einer hohen Gebrauchsqualität wird vorgeschlagen, daß zusätzlich ein Haftvermittler zur Verbesserung eines Anhaftens der Substanz auf einer Oberfläche des Werkstückes abgeschieden wird.

Eine hohe Produktivität kann dadurch unterstützt werden, daß in einer gemeinsamen Kavität mindestens zwei Werkstücke gleichzeitig behandelt werden.

Ein weiteres Anwendungsgebiet besteht darin, daß als Plasmabehandlung eine Plasmasterilisation durchgeführt wird.

Ebenfalls ist daran gedacht, daß als Plasmabehandlung eine Oberflächenaktivierung des Werkstückes durchgeführt wird.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabe- und Ausgaberädern gekoppelt ist.
- Fig. 2: eine Anordnung ähnlich zu Fig. 1, bei der die Plasmastation jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine Darstellung entsprechend Fig. 5 mit geöffneter Plasmakammer,
- Fig. 8: einen Vertikalschnitt gemäß Schnittlinie VIII-VIII in Fig. 7,
- Fig. 9: eine vergrößerte Darstellung der Plasmakammer mit zu beschichtender Flasche gemäß Fig. 6 und
- Fig. 10: eine nochmals vergrößerte Darstellung eines Anschlußelementes zur Halterung des Werkstückes in der Plasmakammer.

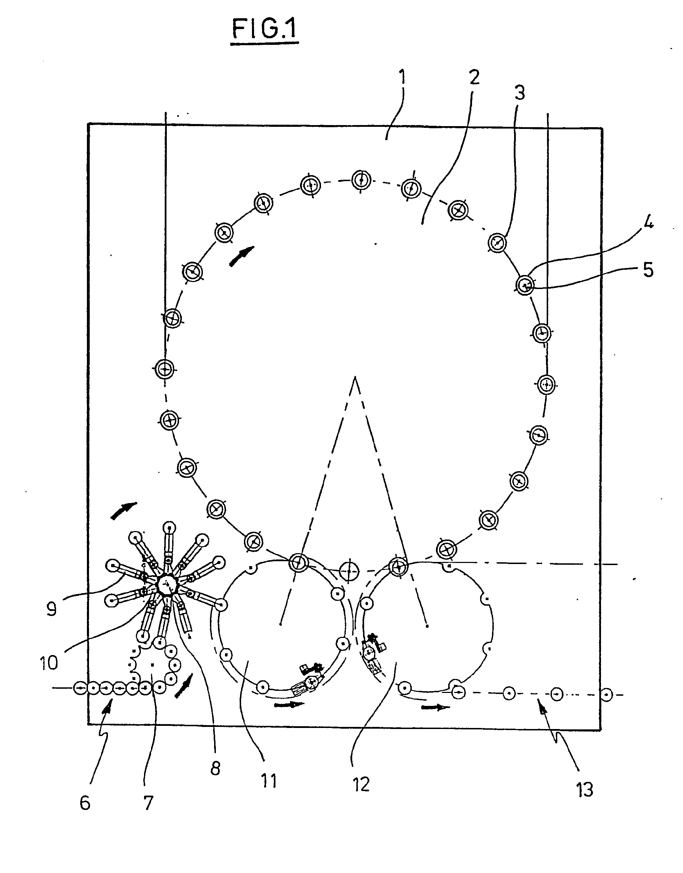

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

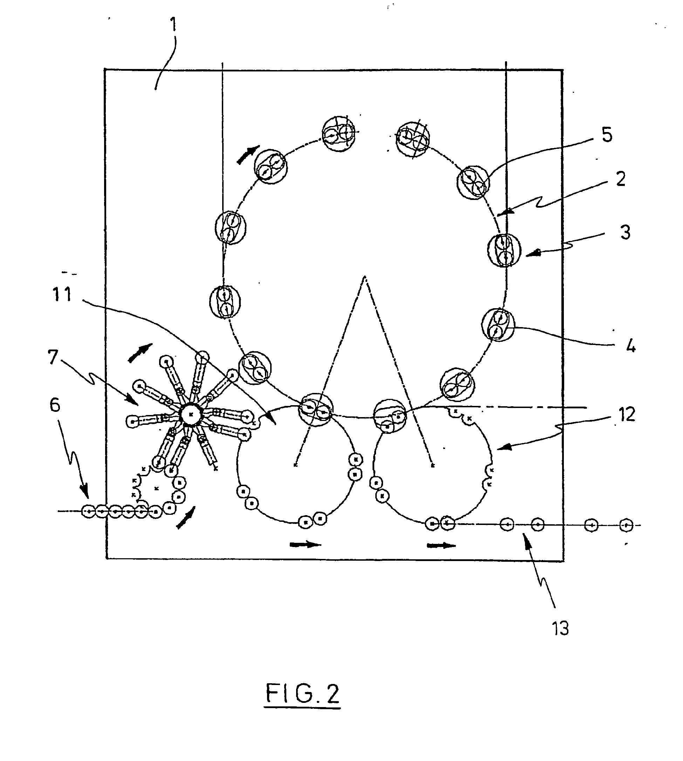

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

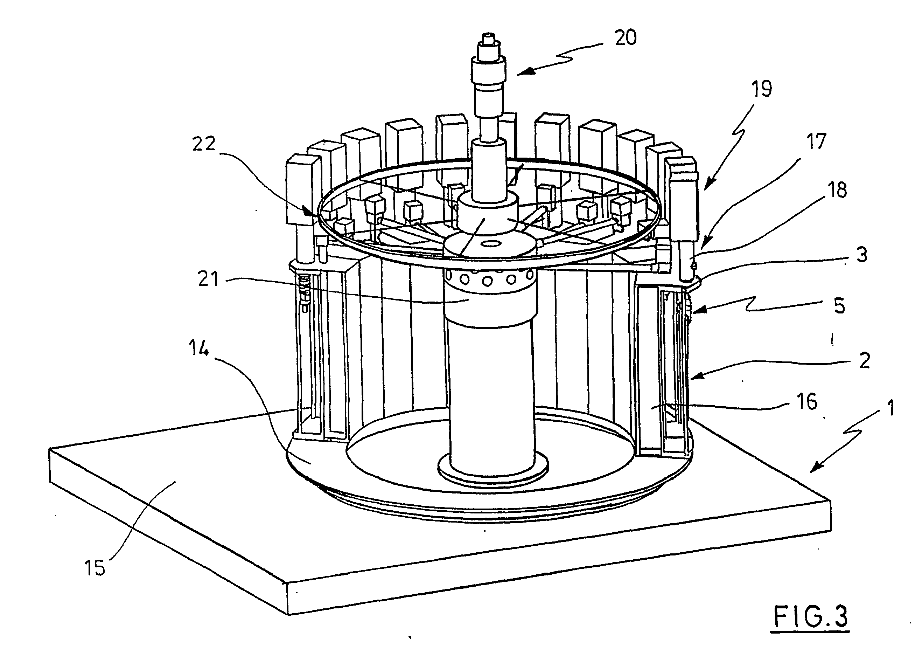

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

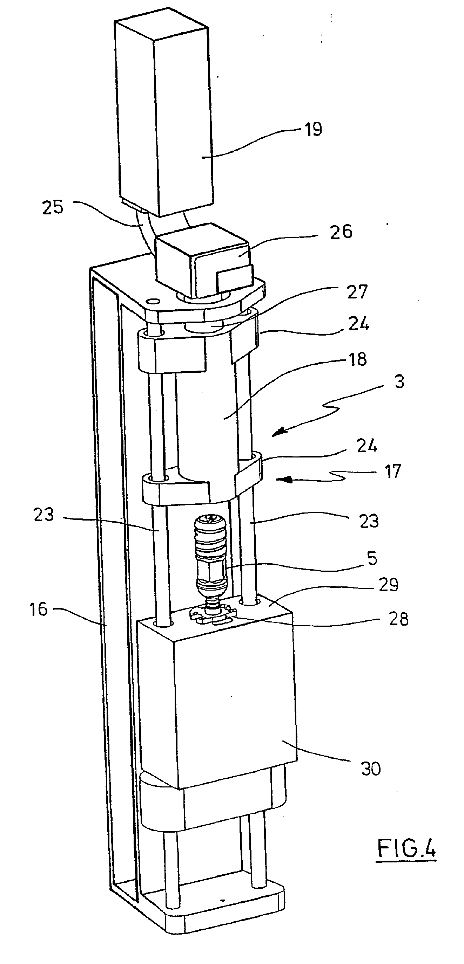

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdekkels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird von einem Halteelement (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

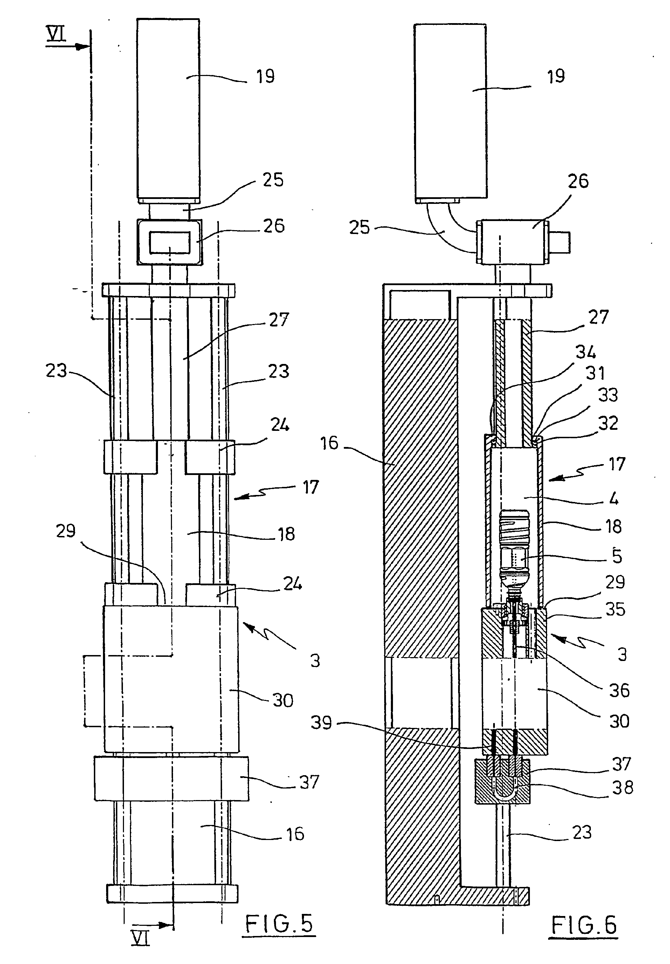

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersokkels (30) eine hohle Lanze (36) angeordnet, die in den Innenraum des Werkstückes (5) hineinverfahrbar ist. Zur Durchführung einer Positionierung der Lanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

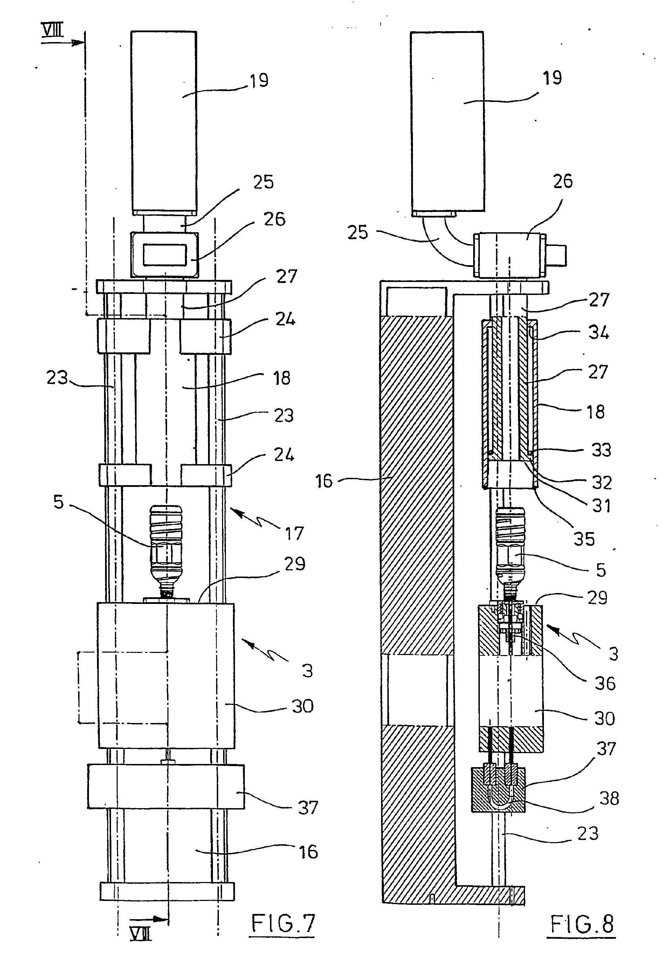

Fig. 7 und Fig. 8 zeigen die Anordnung gemäß Fig. 5 und Fig. 6 in einem angehobenen Zustand der Kammerwandung (18). In diesem Positionierungszustand der Kammerwandung (18) ist es problemlos möglich, das behandelte Werkstück (5) aus dem Bereich der Plasmastation (3) zu entfernen und ein neues zu behandelndes Werkstück (5) einzusetzen. Alternativ zu der in den Zeichnungen dargestellten Positionierung der Kammerwandung (18) in einem durch Verschiebung nach oben erreichten geöffneten Zustand der Plasmakammer (17) ist es auch möglich, den Öffnungsvorgang durch eine Verschiebung einer konstruktiv modifizierten hülsenförmigen Kammerwandung in vertikaler Richtung nach unten durchzuführen.

Im dargestellten Ausführungsbeispiel besitzt der Kopplungskanal (27) eine zylinderförmige Gestaltung und ist im wesentlichen koaxial zur Kammerwandung (18) angeordnet.

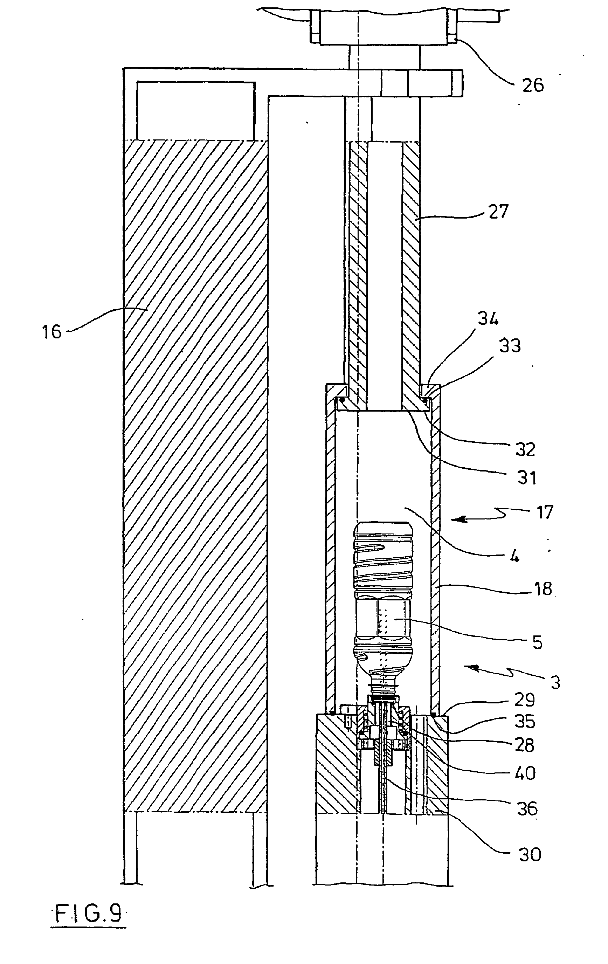

Fig. 9 zeigt den Vertikalschnitt gemäß Fig. 6 in einer vergrößerten teilweisen Darstellung in einer Umgebung der Kammerwandung (18). Zu erkennen ist insbesondere das Übergreifen des Innenflansches (34) der Kammerwandung (18) über den Flansch (32) des Kammerdeckels (31) und die Halterung des Werkstückes (5) durch das Halteelement (28). Darüber hinaus ist zu erkennen, daß die Lanze (36) durch eine Ausnehmung (40) des Halteelementes (28) hindurchgeführt ist.

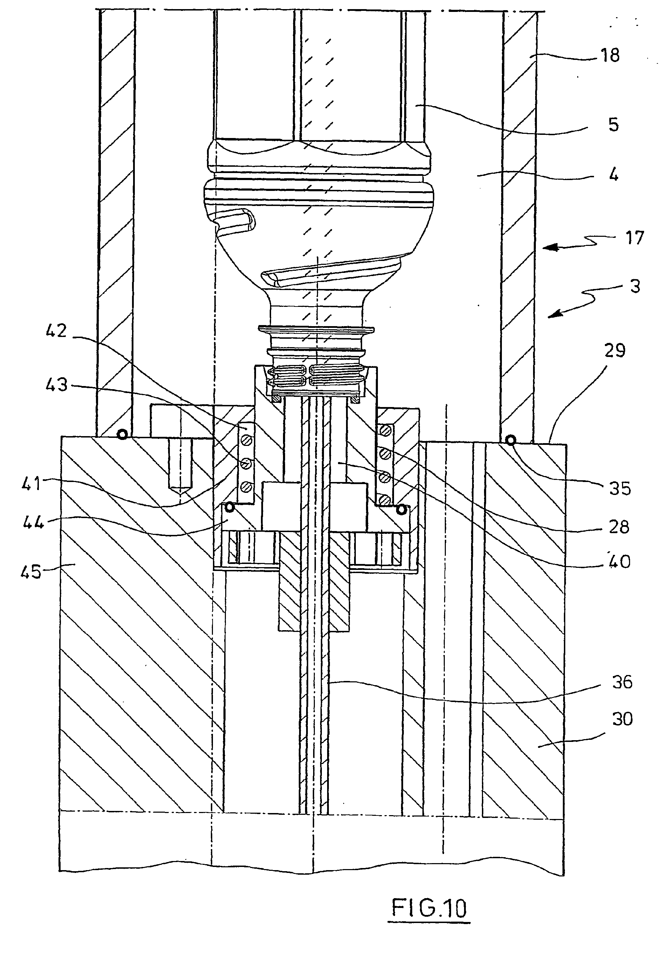

Die Fixierung des Werkstückes (5) durch das Halteelement (28) ist in der nochmals vergrößerten Darstellung in Fig. 10 zu erkennen. Das Halteelement (28) ist in eine Führungshülse (41) eingesetzt, die mit einer Federkammer (42) versehen ist. In die Federkammer (42) ist eine Druckfeder (43) eingesetzt, die einen Außenflansch (44) des Halteelementes (28) relativ zur Führungshülse (41) verspannt.

In der in Fig. 10 dargestellten Positionierung ist ein an der Lanze (36) montierter Schubteller (45) gegen den Außenflansch (44) geführt und drückt das Halteelement (28) in seine obere Endpositionierung. In dieser Positionierung ist ein Innenraum des Werkstückes (5) gegenüber dem Innenraum der Kavität (4) isoliert. In einem abgesenkten Zustand der Lanze (36) verschiebt die Druckfeder (43) das Halteelement (28) relativ zur Führungshülse (41) derart, daß eine Verbindung zwischen dem Innenraum des Werkstückes (5) und dem Innenraum der Kavität (4) geschaffen ist.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Halteelementes (28) eine Abschottung des Innenraumes des Werkstückes (5) gegenüber dem Innenraum der Kavität (4) durchgeführt. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen.

Alternativ zur erläuterten Innenbeschichtung von Werkstükken (5) können auch Außenbeschichtungen, Sterilisationen oder Oberflächenaktivierungen durchgeführt werden.

Eine Positionierung der Kammerwandung (18), des Dichtelementes (28) und / oder der Lanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

## Patentansprüche

1. Verfahren zur Plasmabehandlung von Werkstücken (5), bei dem das Werkstück (5) in eine zumindest teilweise evakuierbare Kammer einer Behandlungsstation eingesetzt wird und bei dem zur Unterstützung einer Handhabung der Werkstücke (5) mindestens ein Teil der Behandlungsstation relativ zu mindestens einem weiteren Teil bewegt wird, **dadurch gekennzeichnet, daß** eine hülsenförmige äußere Kammerwandung (18) relativ zu einem Kammerboden (29) sowie relativ zu einem Kammerdeckel (31) beweglich ist und positioniert wird, daß ein Werkstück (5) aus einem thermoplastischen Kunststoff behandelt wird und daß als Werkstück (5) eine Getränkeflasche behandelt wird, daß die Positionierung in einer vertikalen Richtung durchgeführt wird und daß der Kammerboden (29) und der Kammerdeckel (31) relativ zu einem Stationsrahmen (16) der Plasmastation (3) in einer statischen Positionierung belassen werden und daß die Kammerwandung (18) relativ zum Kammerdeckel (31) abgedichtet wird.

2. Verfahren nach Anspruch 1, **dadurch gekennzeichnet, daß** eine Evakuierung einer Kavität (4) der Plasmastation (3) durch den Kammerboden (29) hindurch erfolgt.

3. Verfahren nach einem der Ansprüche 1 oder 2, **dadurch gekennzeichnet, daß** durch den Kammerboden (29) hindurch Prozeßgas zugeführt wird.

4. Verfahren nach einem der Ansprüche 1 bis 3, **dadurch gekennzeichnet, daß** das Prozeßgas durch eine Lanze (36) hindurch in einen Innenraum des Werkstückes (5) zugeführt wird.

5. Verfahren nach einem der Ansprüche 1 bis 4, **dadurch gekennzeichnet, daß** die Kammerwandung (18) relativ zum Kammerboden (29) abgedichtet wird.

6. Verfahren nach Anspruch 5, **dadurch gekennzeichnet, daß** die Abdichtung von einer mit der Kammerwandung (18) verbundenen Dichtung (35) durchgeführt wird.

7. Verfahren nach einem der Ansprüche 1 bis 6, **dadurch gekennzeichnet, daß** die Abdichtung von einer im Bereich des Kammerdeckels (31) angeordneten Dichtung (33) durchgeführt wird.

8. Verfahren nach Anspruch 7, **dadurch gekennzeichnet, daß** die Abdichtung zwischen einem Innenflansch (34) der Kammerwandung (18) und einem Flansch (32) des Kammerdeckels (31) durchgeführt wird.

9. Verfahren nach einem der Ansprüche 1 bis 8, **dadurch gekennzeichnet, daß** im Bereich des Kammerdeckels (31) von einem Mikrowellengenerator (19) erzeugte Mikrowellen in die Kavität (4) eingeleitet werden.

10. Verfahren nach einem der Ansprüche 1 bis 9, **dadurch gekennzeichnet, daß** der Mikrowellengenerator (19) von einem Kopplungskanal (27) mit dem Innenraum der Kavität (4) verbunden wird.

11. Verfahren nach einem der Ansprüche 1 bis 10, **dadurch gekennzeichnet, daß** ein Innenraum einer Getränkeflasche behandelt wird.

12. Verfahren nach einem der Ansprüche 1 bis 11, **dadurch gekennzeichnet, daß** die mindestens eine Plasmastation (3) von einem rotierenden Plasmarad (2) von einer Eingabepositionierung in eine Ausgabepositionierung überführt wird.

13. Verfahren nach einem der Ansprüche 1 bis 12, **dadurch gekennzeichnet, daß** von einer Plasmastation (3) mehrere Kavitäten (4) bereitgestellt werden.

14. Verfahren nach einem der Ansprüche 1 bis 13, **dadurch gekennzeichnet, daß** eine zur Bereitstellung von mindestens zwei Kavitäten (4) vorgesehene Kammerwandung (18) positioniert wird.

15. Verfahren nach einem der Ansprüche 1 bis 14, **dadurch gekennzeichnet, daß** als Plasmabehandlung eine Plasmabeschichtung durchgeführt wird.

16. Verfahren nach einem der Ansprüche 1 bis 15, **dadurch gekennzeichnet, daß** die Plasmabehandlung unter Verwendung eines Niederdruckplasmas durchgeführt wird.

17. Verfahren nach einem der Ansprüche 1 bis 16, **dadurch gekennzeichnet, daß** eine Plasmapolymerisation durchgeführt wird.

18. Verfahren nach einem der Ansprüche 1 bis 17, **dadurch gekennzeichnet, daß** durch das Plasma mindestens zum Teil organische Substanzen abgeschieden werden.

19. Verfahren nach einem der Ansprüche 1 bis 17, **dadurch gekennzeichnet, daß** durch das Plasma mindestens zum Teil anorganische Substanzen abgeschieden werden.

20. Verfahren nach einem der Ansprüche 1 bis 19, **dadurch gekennzeichnet, daß** durch das Plasma eine Substanz zur Verbesserung von Barriereeigenschaften des Werkstückes (5) abgeschieden wird.

21. Verfahren nach Anspruch 20, **dadurch gekennzeichnet, daß** zusätzlich ein Haftvermittler zur Verbesserung eines Anhaftens der Substanz auf einer Oberfläche des Werkstückes (5) abgeschieden wird.

22. Verfahren nach einem der Ansprüche 1 bis 21, **dadurch gekennzeichnet, daß** in einer gemeinsamen Kavität mindestens zwei Werkstücke (5) gleichzeitig behandelt werden.

23. Verfahren nach einem der Ansprüche 1 bis 14, **dadurch gekennzeichnet, daß** als Plasmabehandlung eine Plasmasterilisation durchgeführt wird.

24. Verfahren nach einem der Ansprüche 1 bis 14, **dadurch gekennzeichnet, daß** als Plasmabehandlung eine Oberflächenaktivierung des Werkstückes (5) durchgeführt wird.

25. Vorrichtung zur Plasmabehandlung von Werkstücken (5), die mindestens eine evakuierbare Plasmakammer zur Aufnahme der Werkstücke (5) aufweist und bei der die Plasmakammer im Bereich einer Behandlungsstation angeordnet ist, sowie bei der die Plasmakammer von einem Kammerboden (29), einem Kammerdeckel (31) sowie einer äußeren seitlichen Kammerwandung (18) begrenzt ist, **dadurch gekennzeichnet, daß** die Kammerwandung (18) hülsenförmig ausgebildet und sowohl relativ zum Kammerboden (29) als auch relativ zum Kammerdeckel (31) beweglich angeordnet ist und daß die Plasmastation (3) zur Beschichtung eines Werkstückes (5) in Form einer Getränkeflasche aus einem thermoplastischen Material ausgebildet ist, daß die Kammerwandung (18) in einer vertikalen Richtung durch eine Verschiebung der Kammerwandung (18) positionierbar ist und daß der Kammerboden (29) und der Kammerdeckel (31) relativ zu einem Stationsrahmen (16) der Plasmastation (3) in einer statischen Positionierung angeordnet sind und daß die Kammerwandung (18) relativ zum Kammerdeckel (31) abgedichtet ist.

26. Vorrichtung nach Anspruch 25, **dadurch gekennzeichnet, daß** für eine Evakuierung einer Kavität (4) der Plasmastation (3) im Kammerboden (29) mindestens ein Vakuumkanal angeordnet ist.

27. Vorrichtung nach einem der Ansprüche 25 oder 26, **dadurch gekennzeichnet, daß** im Kammerboden (29) mindestens ein Kanal zur Zuführung von Prozeßgas angeordnet ist.

28. Vorrichtung nach einem der Ansprüche 25 bis 27, **dadurch gekennzeichnet, daß** zur Zuführung von Prozeßgas in einen Innenraum des Werkstückes (5) hinein eine Lanze (36) relativ zum Kammerboden (29) positionierbar angeordnet ist.

29. Vorrichtung nach einem der Ansprüche 25 bis 28, **dadurch gekennzeichnet, daß** die Kammerwandung (18) relativ zum Kammerboden (29) abgedichtet ist.

30. Vorrichtung nach einem der Ansprüche 25 bis 28, **dadurch gekennzeichnet, daß** zur Abdichtung im Bereich der Kammerwandung (18) eine Dichtung (35) angeordnet ist.

31. Vorrichtung nach einem der Ansprüche 25 bis 30, **dadurch gekennzeichnet, daß** zur Abdichtung im Bereich des Kammerdeckels (31) eine Dichtung (33) angeordnet ist.

32. Vorrichtung nach einem der Ansprüche 25 bis 31, **dadurch gekennzeichnet, daß** die Dichtung (33) zwischen einem Innenflansch (34) der Kammerwandung (18) und einem Flansch (32) des Kammerdeckels (31) angeordnet ist.

33. Vorrichtung nach einem der Ansprüche 25 bis 32, **dadurch gekennzeichnet, daß** im Bereich des Kammerdeckels (31) ein Mikrowellengenerator (19) angeordnet ist.

34. Vorrichtung nach einem der Ansprüche 25 bis 33, **dadurch gekennzeichnet, daß** der Mikrowellengenerator (19) von einem Kopplungskanal (27) mit dem Innenraum der Kavität (4) verbunden ist.

35. Vorrichtung nach einem der Ansprüche 25 bis 34, **dadurch gekennzeichnet, daß** die Plasmastation (3) zur Beschichtung eines Werkstückes (5) in Form einer Getränkeflasche aus einem thermoplastischen Kunststoff ausgebildet ist.

36. Vorrichtung nach einem der Ansprüche 25 bis 35, **dadurch gekennzeichnet, dass** die Plasmastation (3) zur Beschichtung eines Innenraumes einer Getränkeflasche ausgebildet ist.

37. Vorrichtung nach einem der Ansprüche 25 bis 36, **dadurch gekennzeichnet, dass** die mindestens eine Plasmastation (3) von einem rotierenden Plasmarad (2) getragen ist.

38. Vorrichtung nach einem der Ansprüche 25 bis 37, **dadurch gekennzeichnet, dass** im Bereich der Plasmastation (3) mehrere Kavitäten (4) angeordnet sind.

39. Vorrichtung nach einem der Ansprüche 25 bis 38, **dadurch gekennzeichnet, dass** eine zur Bereitstellung von mindestens zwei Kavitäten (4) vorgesehene Kammerwandung (18) positionierbar angeordnet ist.

## Claims

1. A method for the plasma treatment of workpieces (5) wherein the workpiece (5) is inserted into a chamber of a treatment station, wherein said chamber can be evacuated at least in part, and wherein at least a part of the treatment station can be moved in relation to at least another part to support a handling of the workpieces (5), **characterised in that** a sleeve-type outer chamber wall (18) is movable and positioned in relation to a chamber bottom (29) as well as in relation to a chamber cover (31), that a workpiece (5) that is made of thermoplastic hard resin is treated and that a beverage bottle is treated as workpiece (5), that the positioning is carried out in a vertical direction and that the chamber bottom (29) and the chamber cover (31) are left in a static position in relation to a station frame (16) of the plasma station (3), and that the chamber wall (18) is sealed in relation to the chamber cover (31).

2. The method according to Claim 1, **characterised in that** an evacuation of a cavity (4) of the plasma station (3) is achieved through the chamber bottom (29).

3. The method according to any one of Claims 1 or 2, **characterised in that** process gas is supplied through the chamber bottom (29).

4. The method according to any one of Claims 1 to 3, **characterised in that** the process gas is supplied through a lance (36) and into an interior region of the workpiece (5).

5. The method according to any one of Claims 1 to 4, **characterised in that** the chamber wall (18) is sealed in relation to the chamber bottom (29).

6. The method according to Claim 5, **characterised in that** the sealing is achieved by means of a seal (35) that is connected to the chamber wall (18).

7. The method according to any one of Claims 1 to 6, **characterised in that** the sealing is achieved by means of a seal (33) that is arranged in the vicinity of the chamber cover (31).

8. The method according to Claim 7, **characterised in that** the sealing is achieved between an inner flange (34) of the chamber wall (18) and a flange (32) of the chamber cover (31).

9. The method according to any one of Claims 1 to 8, **characterised in that** microwaves that are generated by a microwave generator (19) in the vicinity of the chamber cover (31) are introduced into the cavity (4).

10. The method according to any one of Claims 1 to 9, **characterised in that** the microwave generator (19) is connected to the interior region of the cavity (4) via a coupling duct (27).

11. The method according to any one of Claims 1 to 10, **characterised in that** an interior region of a beverage bottle is treated.

12. The method according to any one of Claims 1 to 11, **characterised in that** a rotating plasma wheel (2) transfers the at least one plasma station (3) from an input position to an output position.

13. The method according to any one of Claims 1 to 12, **characterised in that** a plurality of cavities (4) is provided by a plasma station (3).

14. The method according to any one of Claims 1 to 13, **characterised in that** a chamber wall (18) that is provided for making at least two cavities (4) available is positioned.

15. The method according to any one of Claims 1 to 14, **characterised in that** plasma coating is carried out as plasma treatment.

16. The method according to any one of Claims 1 to 15, **characterised in that** the plasma treatment is carried out with use being made of low pressure plasma.

17. The method according to any one of Claims 1 to 16, **characterised in that** plasma polymerisation is carried out.

18. The method according to any one of Claims 1 to 17, **characterised in that** organic substances are separated by the plasma at least in part.

19. The method according to any one of Claims 1 to 17, **characterised in that** inorganic substances are separated by the plasma at least in part.

20. The method according to any one of Claims 1 to 19, **characterised in that** a substance for improving barrier properties of the workpiece (5) is separated by the plasma.

21. The method according to Claim 20, **characterised in that** an adhesion promoter for improving an adhesion of the substance to a surface of the workpiece (5) is additionally separated.

22. The method according to any one Claims 1 to 21, **characterised in that** at least two workpieces (5) are simultaneously treated in a common cavity.

23. The method according to any one of Claims 1 to 14, **characterised in that** plasma sterilisation is carried out as plasma treatment.

24. The method according to any one of Claims 1 to 14, **characterised in that** surface activation of the workpiece (5) is carried out as plasma treatment.

25. A device for the plasma treatment of workpieces (5), the device including at least one plasma chamber for receiving the workpiece (5), wherein said plasma chamber can be evacuated, wherein the plasma chamber is arranged in the vicinity of the treatment station, and wherein the plasma chamber is delimited by a chamber bottom (29), a chamber cover (31) as well as an outer lateral chamber wall (18), **characterised in that** the chamber wall (18) is formed in the shape of a sleeve and is arranged such that it is movable in relation to the chamber bottom (29) as well as in relation to the chamber cover (31), and that the plasma station (3) for coating a workpiece (5) having the form of a beverage bottle is made of a thermoplastic material, that the chamber wall (18) can be positioned in a vertical direction by displacing the chamber wall (18), and that the chamber bottom (29) and the chamber cover (31) are arranged in a static position in relation to a station frame (16) of the plasma station (3), and that the chamber wall (18) is sealed in relation to the chamber cover (31).

26. The device according to Claim 25, **characterised in that** at least one vacuum duct is arranged in the chamber bottom (29) for evacuating a cavity (4) of the plasma station (3).

27. The device according to any one of Claims 25 or 26, **characterised in that** at least one duct for supplying process gas is arranged in the chamber bottom (29).

28. The device according to any one of Claims 25 to 27, **characterised in that**, for supplying process gas into an interior region of the workpiece (5), a lance (36) is arranged such that it can be positioned in relation to the chamber bottom (29).

29. The device according to any one of Claims 25 to 28, **characterised in that** the chamber wall (18) is sealed in relation to the chamber bottom (29).

30. The device according to any one of Claims 25 to 28, **characterised in that** a seal (35) is arranged in the vicinity of the chamber wall (18) for sealing purposes.

31. The device according to any one of Claims 25 to 30, **characterised in that** a seal (33) is arranged in the vicinity of the chamber cover (31) for sealing purposes.

32. The device according to any one of Claims 25 to 31, **characterised in that** the seal (33) is arranged between an inner flange (34) of the chamber wall (18) and a flange (32) of the chamber cover (31).

33. The device according to any one of Claims 25 to 32, **characterised in that** a microwave generator (19) is arranged in the vicinity of the chamber cover (31).

34. The device according to any one of Claims 25 to 33, **characterised in that** the microwave generator (19) is connected to the interior region of the cavity (4) via a coupling duct (27).

35. The device according to any one of Claims 25 to 34, **characterised in that** the plasma station (3) for coating a workpiece (5) having the form of a beverage bottle is made of thermoplastic hard resin.

36. The device according to any one of Claims 25 to 35, **characterised in that** the plasma station (3) is formed for coating an interior region of a beverage bottle.

37. The device according to any one of Claims 25 to 36, **characterised in that** the at least one plasma station (3) is held by a rotating plasma wheel (2).

38. The device according to any one of Claims 25 to 37, **characterised in that** a plurality of cavities (4) is arranged in the vicinity of the plasma station (3).

39. The device according to any one of Claims 25 to 38, **characterised in that** a chamber wall (18) that is provided for making at least two cavities (4) available is arranged such that it can be positioned.

## Revendications

1. Procédé de traitement au plasma de pièces d'oeuvre (5) dans le cadre duquel la pièce (5) est introduite dans une chambre d'une station de traitement pouvant, en partie au moins, être évacuée, et dans le cadre duquel une partie au moins de la station de traitement est déplacée par rapport à au moins une autre partie pour assister une manipulation des pièces d'oeuvre (5), **caractérisé en ce qu'**une paroi extérieure (18) de la chambre en forme de manchon est mobile et positionnée par rapport à un fond (29) de la chambre et par rapport à un couvercle (31) de la chambre, qu'une pièce d'oeuvre (5) en une matière thermoplastique est traitée et qu'en guise de pièce d'oeuvre (5) est traitée une bouteille pour boissons, que le positionnement est effectué en sens vertical et que le fond (29) et le couvercle (31) de la chambre sont maintenus en une position statique par rapport au châssis (16) de la station de plasma (3), et **en ce que** la paroi (18) de la chambre est étanchéifiée par rapport au couvercle (31) de la chambre.

2. Procédé selon la revendication 1, **caractérisé en ce qu'**une évacuation d'une cavité (4) de la station de plasma (3) a lieu à travers le fond (29) de la chambre.

3. Procédé selon l'une des revendications 1 ou 2, **caractérisé en ce qu'**un gaz de procédé est introduit par le fond (29) de la chambre.

4. Procédé selon l'une des revendications 1 à 3, **caractérisé en ce que** le gaz de procédé est introduit par une lance (36) dans un espace intérieur de la pièce d'oeuvre (5).

5. Procédé selon l'une des revendications 1 à 4, **caractérisé en ce que** la paroi (18) de la chambre est étanchéifiée par rapport au fond (29) de la chambre.

6. Procédé selon la revendication 5, **caractérisé en ce que** l'étanchéification est assurée par un joint (35) associé à la paroi (18) de la chambre.

7. Procédé selon l'une des revendications 1 à 6, **caractérisé en ce que** l'étanchéification est assurée par un joint (33) agencé au niveau du couvercle (31) de la chambre.

8. Procédé selon la revendication 7, **caractérisé en ce que** l'étanchéification est réalisée entre une collerette intérieure (34) de la paroi (18) de la chambre et une collerette (32) du couvercle (31) de la chambre.

9. Procédé selon l'une des revendications 1 à 8, **caractérisé en ce que** des micro-ondes produites par un générateur de micro-ondes (19) sont introduites dans la cavité (4) au niveau du couvercle (31) de la chambre.

10. Procédé selon l'une des revendications 1 à 9, **caractérisé en ce que** le générateur de micro-ondes (19) est relié à l'espace intérieur de la cavité (4) par un canal de couplage (27).

11. Procédé selon l'une des revendications 1 à 10, **caractérisé en ce qu'**un espace intérieur d'une bouteille pour boissons est traité.

12. Procédé selon l'une des revendications 1 à 11, **caractérisé en ce que** la ou les station(s) de plasma (3) est ou sont déplacée(s) d'un positionnement d'introduction en un positionnement de sortie par une roue de traitement au plasma (2) en rotation.

13. Procédé selon l'une des revendications 1 à 12, **caractérisé en ce qu'**une station de plasma (3) met à disposition plusieurs cavités (4).

14. Procédé selon l'une des revendications 1 à 13, **caractérisé en ce qu'**une paroi (18) de la chambre conçue pour mettre à disposition au moins deux cavités (4) est positionnée.

15. Procédé selon l'une des revendications 1 à 14, **caractérisé en ce que** le traitement au plasma est réalisé sous forme de revêtement par plasma.

16. Procédé selon l'une des revendications 1 à 15, **caractérisé en ce que** le traitement au plasma fait appel à un plasma basse pression.

17. Procédé selon l'une des revendications 1 à 16, **caractérisé en ce que** l'on effectue une polymérisation par plasma.

18. Procédé selon l'une des revendications 1 à 17, **caractérisé en ce que** le plasma dépose en partie au moins des substances organiques.

19. Procédé selon l'une des revendications 1 à 17, **caractérisé en ce que** le plasma dépose en partie au moins des substances anorganiques.

20. Procédé selon l'une des revendications 1 à 19, **caractérisé en ce que** le plasma dépose une substance améliorant les propriétés de barrière de la pièce d'oeuvre (5).

21. Procédé selon la revendication 20, **caractérisé en ce qu'**est en outre déposé un agent de pontage pour améliorer l'adhésion de la substance à la surface de la pièce d'oeuvre (5).

22. Procédé selon l'une des revendications 1 à 21, **caractérisé en ce que** deux pièces d'oeuvre (5) au moins sont traitées simultanément dans une cavité commune.

23. Procédé selon l'une des revendications 1 à 14, **caractérisé en ce que** le traitement au plasma appliqué est une stérilisation par plasma.

24. Procédé selon l'une des revendications 1 à 14, **caractérisé en ce que** le traitement au plasma appliqué est une activation de surface de la pièce d'oeuvre (5).

25. Dispositif de traitement au plasma de pièces d'oeuvre (5) présentant, pour recevoir ces pièces (5), au moins une chambre à plasma pouvant être évacuée agencée dans la zone d'une station de traitement, cette chambre à plasma étant délimitée par un fond de chambre (29), un couvercle de chambre (31) ainsi qu'une paroi latérale extérieure (18), **caractérisé en ce que** la paroi (18) de la chambre est réalisée en forme de manchon et agencée de façon à être mobile aussi bien par rapport au fond (29) qu'au couvercle (31) de la chambre, que la station de plasma (3) est conçue pour appliquer un revêtement à l'intérieur d'une pièce d'oeuvre (5) en forme de bouteille pour boissons en matière plastique thermoplastique, que la paroi (18) de la chambre peut être positionnée en sens vertical par un déplacement de la paroi (18) et **en ce que** le fond (29) et le couvercle (31) de la chambre sont agencés en une position statique par rapport au châssis (16) de la station de plasma (3), et que la paroi (18) de la chambre est étanchéifiée par rapport au couvercle (31) de la chambre.

26. Dispositif selon la revendication 25, **caractérisé en ce qu'**un canal à vide au moins est aménagé dans le fond (29) de la chambre pour l'évacuation d'une cavité (4) de la station de plasma (3).

27. Dispositif selon l'une des revendications 25 ou 26, **caractérisé en ce qu'**un canal au moins est aménagé dans le fond (29) de la chambre pour l'adduction d'un gaz de procédé.

28. Dispositif selon l'une des revendications 25 à 27, **caractérisé en ce qu'**une lance (36) pour l'adduction d'un gaz de procédé dans un espace intérieur de la pièce d'oeuvre (5) est agencée de façon à pouvoir être positionnée par rapport au fond (29) de la chambre.

29. Dispositif selon l'une des revendications 25 à 28, **caractérisé en ce que** la paroi (18) de la chambre est étanchéifiée par rapport au fond (29) de la chambre.

30. Dispositif selon l'une des revendications 25 à 28, **caractérisé en ce qu'**un joint (35) est placé au niveau de la paroi (18) de la chambre pour assurer l'étanchéification.

31. Dispositif selon l'une des revendications 25 à 30, **caractérisé en ce qu'**un joint (33) est placé au niveau du couvercle (31) de la chambre pour assurer l'étanchéification.

32. Dispositif selon l'une des revendications 25 à 31, **caractérisé en ce que** le joint (33) est placé entre une collerette intérieure (34) de la paroi (18) de la chambre et une collerette (32) du couvercle (31) de la chambre.

33. Dispositif selon l'une des revendications 25 à 32, **caractérisé en ce qu'**un générateur de micro-ondes (19) est placé au niveau du couvercle (31) de la chambre.

34. Dispositif selon l'une des revendications 25 à 33, **caractérisé en ce que** le générateur de micro-ondes (19) est relié à l'espace intérieur de la cavité (4) par un canal de couplage (27).

35. Dispositif selon l'une des revendications 25 à 34, **caractérisé en ce que** la station de plasma (3) est conçue pour appliquer un revêtement à l'intérieur d'une pièce d'oeuvre (5) en forme de bouteille pour boissons en matière plastique thermoplastique.

36. Dispositif selon l'une des revendications 25 à 35, **caractérisé en ce que** la station de plasma (3) est conçue pour appliquer un revêtement dans l'espace intérieur d'une bouteille pour boissons.

37. Dispositif selon l'une des revendications 25 à 36, **caractérisé en ce que** la ou les station(s) de plasma (3) est ou sont portée(s) par une roue de traitement au plasma (2) en rotation.

38. Dispositif selon l'une des revendications 25 à 37, **caractérisé en ce que** plusieurs cavités (4) sont agencées dans la zone de la station de plasma (3).

39. Dispositif selon l'une des revendications 25 à 38, **caractérisé en ce qu'**une paroi (18) prévue pour mettre à disposition au moins deux cavités (4) est placée de façon à pouvoir être positionnée.
